# EUROPÄISCHE PATENTSCHRIFT

(11) **EP 0 748 486 B1**
(45) Veröffentlichungstag und Bekanntmachung des Hinweises auf die Patenterteilung: **25.11.1998**
(21) Anmeldenummer: 95909784.1
(22) Anmeldetag: 25.02.1995
(51) Int. Cl.: G06K 19/077, H05K 5/02

(54) **STECKKARTE FÜR ELEKTRONISCHE DATENVERARBEITUNGSGERÄTE UND VERFAHREN ZU DEREN HERSTELLUNG UND MONTAGE**
INSERT CARD FOR ELECTRONIC DATA PROCESSING EQUIPMENT AND PROCESS FOR ITS PRODUCTION AND FITTING
CARTE ENFICHABLE POUR APPAREILS ELECTRONIQUES DE TRAITEMENT DE DONNEES ET SON PROCEDE DE FABRICATION ET DE MONTAGE

(30) Priorität: 01.03.1994 DE 4406644
(43) Veröffentlichungstag der Anmeldung: 18.12.1996
(73) Patentinhaber: ITT Cannon GmbH, D-71384 Weinstadt (DE)
(72) Erfinder: FROMMER, Jürgen, D-70736 Fellbach (DE); ILLG, Manfred, D-71384 Weinstadt (DE); ETZKORN, Roland, D-71394 Kernen (DE); BAGINY, Michael, Duane, D-71384 Weinstadt (DE)
(74) Vertreter: Dreiss, Fuhlendorf, Steimle & Becker, Patentanwälte
(86) Internationale Anmeldenummer: EP9500691
(87) Internationale Veröffentlichungsnummer: WO9524020

(56) Entgegenhaltungen:
- EP-A- 0 382 141
- EP-A- 0 584 728
- EP-A- 0 619 697
- WO-A-91/18451
- WO-A-94/14306
- US-A- 5 339 222

## Beschreibung

Die vorliegende Erfindung bezieht sich auf eine Steckkarte für elektronische Datenverarbeitungsgeräte nach dem Oberbegriff des Anspruchs 1 und auf ein Verfahren zum Herstellen und Montieren einer solchen Steckkarte nach dem Oberbegriff des Anspruchs 8.

Bekannte Steckkarten dieser Art, wie sie bspw. als Speicherkarten, Modemkarten, Faxkarten und dgl. im PCMCIA-Standard angeboten werden, besitzen einen Kunststoffrahmen, auf dem der oder die Steckverbinder befestigt sind und innerhalb dessen die mit elektronischen Bauelementen bestückte Leiterplatte angeordnet und gehalten ist. Zu beiden Seiten dieses so bestückten Kunststoffrahmens sind Metalldeckel aufgebracht, damit die Leiterplatte und deren Bauelemente durch äußere mechanische Einwirkungen nicht beschädigt werden können. Da der schwierig herzustellende und zu verarbeitende Kunststoffrahmen nur eine unzureichende Stabilität bietet, müssen die Metalldeckel aufwendig verklebt oder verschweißt werden, damit die so zusammengebaute Steckkarte biegefest und verwindungssteif ist. Zur Verringerung der Anzahl der notwendigen Bauteile ist auch schon versucht worden, die Steckverbinder in den Rahmen zu integrieren, jedoch hat dies die Kontaktmontage erheblich erschwert. Ein weiteres Problem bei diesen bekannten Steckkarten besteht darin, daß die Schirmung gegen äußere elektromagnetische Einflüsse im Bereich der Rahmenaußenkanten, insbesondere der Rahmenlängskanten nicht gegeben ist.

Aus der WO 91/18451 ist eine Steckkarte für digitale Kommunikationsgeräte der eingangs genannten Art bekannt geworden, dessen halbschalenartig ausgebildete Gehäuseteile aus Kunststoff geformt und miteinander verbunden sind. Eine elektromagnetische Abschirmung des aufgrund des verwendeten Materials eine ausreichende Stabilität aufweisenden Gehäuses ist nicht vorgesehen.

Aufgabe der vorliegenden Erfindung ist es deshalb, eine Steckkarte der eingangs genannten Art zu schaffen, die, ohne die Qualität der mechanischen Stabilität negativ zu beeinflussen, bei verringerter Anzahl von Bauteilen in einfacherer und kostengünstigerer Weise hergestellt werden kann und die gleichzeitig eine ausreichende elektromagnetische Abschirmung besitzt. Desweiteren soll ein schnelles und einfaches Verfahren zum Herstellen und Montieren einer solchen Steckkarte angegeben werden.

Zur Lösung dieser Aufgabe sind bei einer Steckkarte für elektronische Datenverarbeitungsgeräte der genannten Art die im Anspruch 1 angegebenen Merkmale und bei einem Verfahren zum Herstellen und Montieren einer derartigen Steckkarte die im Anspruch 8 angegebenen Merkmale vorgesehen.

Durch die erfindungsgemäßen Maßnahmen ist eine Steckkarte gegeben, die ohne Rahmenbauteil auskommt und damit von der Anzahl der Bauteile her weniger aufwendig ist. Desweiteren entfällt die Verbindung zwischen Steckverbinder und Rahmen, wobei die ohnehin vorzunehmende Verbindung Steckverbindung und Leiterplatte verbleibt. Die mechanische Verwindungssteifigkeit bzw. Stabilität wird ausschließlich durch die miteinander zu verrastenden Gehäuseteile erreicht, wobei eine flächige Verklebung oder Verschweißung entfällt. Diese Art der Montage der beiden Gehäuseteile kann in sehr einfacher und schneller Weise erfolgen. Desweiteren wird eine verbesserte elektromagnetische Abschirmung erreicht, da die Gehäuseteile zumindest längs der Längsseiten der Steckkarte einander überdecken. Ein weiterer Vorteil besteht darin, daß die Leiterplatte innerhalb der Steckkarte um den sonst für den Rahmen benötigten Platz vergrößert werden kann.

Das erfindungsgemäße Verfahren führt zu einer einfachen und schnellen Montage der Steckkarten aus der reduzierten Anzahl der Bauteile. Nach wie vor können die Steckverbinder separat und damit in einfacher Weise realisiert werden. Die in einfacher Weise zusammenzufügende Baueinheit aus Leiterplatte und ein oder zwei Steckverbindern kann in unkomplizierter Weise in dem einen Gehäuseteil unverrückbar fixiert werden, so daß der andere Gehäuseteil aufgerastet werden kann, ohne daß besondere Maßnahmen für das Halten von Leiterplatte und Steckverbinder im einen Gehäuseteil vorgesehen werden müssen. Dadurch ergibt sich eine erhebliche Kostenreduzierung.

Mit den Merkmalen gemäß Anspruch 2 und/oder 3 ist erreicht, daß zum Verrasten der beiden Gehäuseteile eine örtliche Vorfixierung des einen zum anderen Gehäuseteil über einen der Steckverbinder erreicht ist. Dabei ist es zweckmäßig die Merkmale gemäß Anspruch 4 vorzusehen, so daß die Verrastung der beiden Gehäuseteile miteinander durch eine Schwenkbewegung erfolgen kann.

Um eine unkomplizierte und ggf. auch maschinell ausführbare Verrastung der beiden Gehäuseteile zu erreichen, können die Merkmale gemäß Anspruch 5 vorgesehen sein. Dadurch ergibt sich zu Beginn der Schwenkbewegung eine Führung der beiden Gehäuseteile aneinander, was die Schnelligkeit und Zuverlässigkeit der Verrastung erhöht.

Mit den Merkmalen gemäß Anspruch 6 ist eine weitere Erhöhung der Verwindungssteifigkeit und der Stabilität im Bezug auf die Planheit gegeben. Diese Abkröpfung nimmt in vorteilhafter Weise die Materialspannungen, die durch die anderen Abkantungen entstehen.

Zum zuverlässigen Vermeiden elektrischer Entladungen bzw. zum zuverlässigen Erreichen eines Überspannungsschutzes sind die Merkmale gemäß Anspruch 7 vorgesehen. Die Realisierung dieser Maßnahmen ist ohne Rahmen durch bloßes Aufeinanderlegen von Gehäuseteil und Leiterplatte wesentlich vereinfacht.

Weitere Einzelheiten der Erfindung sind der folgenden Beschreibung zu entnehmen, in der die Erfindung anhand des in der Zeichnung dargestellten Ausführungsbeispieles näher beschrieben und erläutert ist. Es zeigen:
- Figur 1A und 1B: in perspektivischer Darstellung ein unteres bzw. ein oberes Gehäuseteil einer Steckkarte gemäß einem bevorzugten Ausführungsbeispiel vorliegender Erfindung,
- Figur 2: in teilweise abgebrochener vergrößerter perspektivischer und gedrehter Darstellung eine Einzelheit gemäß Kreis II der Figur 1A,
- Figur 3: in vergrößerter Darstellung einen Schnitt längs der Linie III-III der Figur 4F und
- Figuren 4A bis 4F: eine Darstellung der schrittweisen Montage der Steckkarte gemäß dem bevorzugten Ausführungsbeispiel aus deren einzelnen Bauteilen.

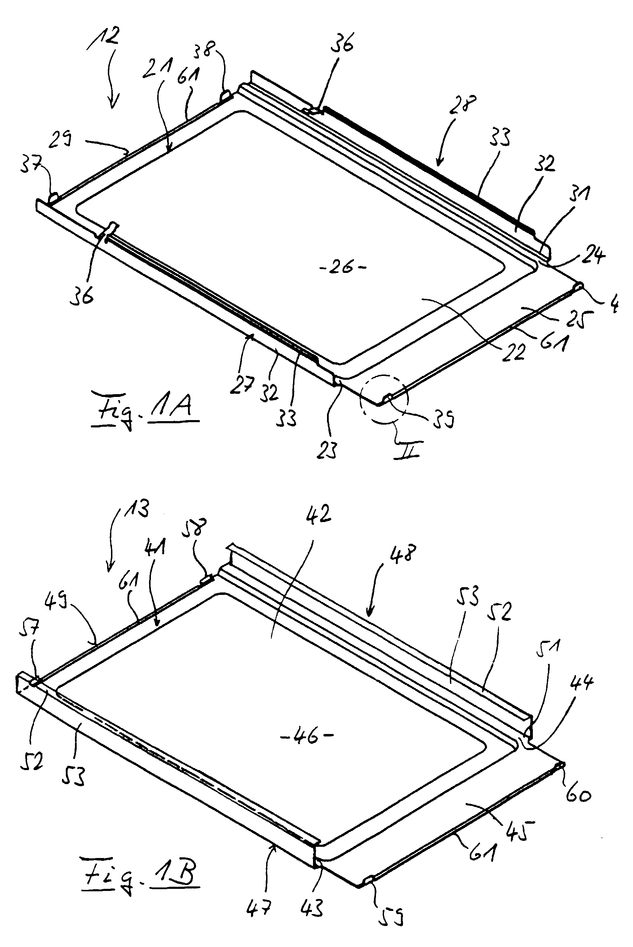

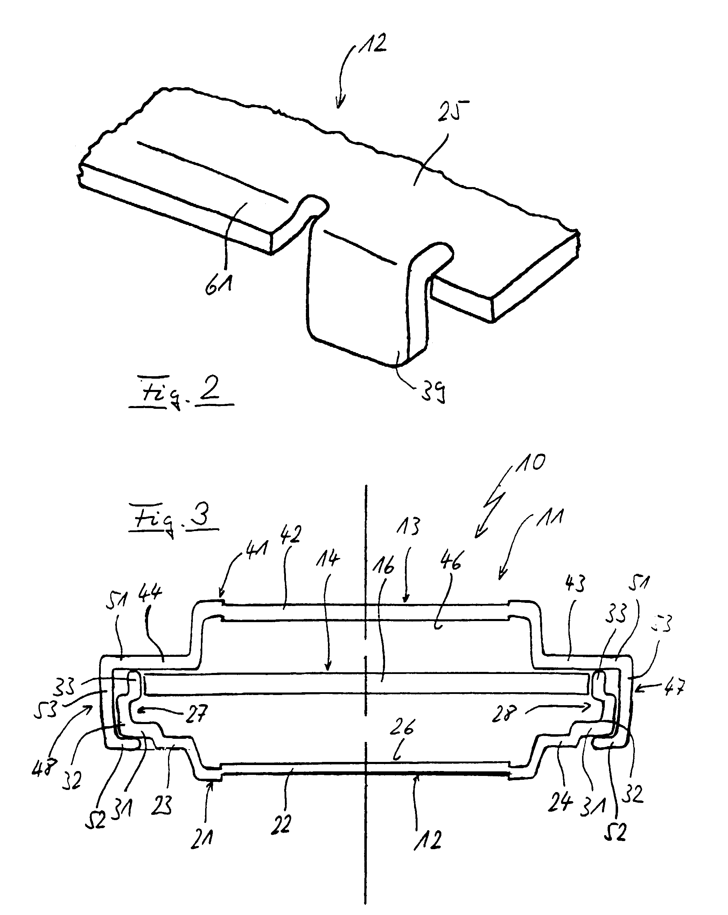

Die in den Figuren 3 und 4F in zusammengebautem Zustand dargestellte rahmenlose Steckkarte 10 für elektronische Datenverarbeitungsgeräte besitzt ein länglich rechteckiges und sehr flaches Gehäuse 11, das aus einem unteren Gehäuseteil 12 und einem damit verrastend verbundenen oberen Gehäuseteil 13 zusammengesetzt ist. Zwischen den beiden Gehäuseteilen 12 und 13 ist eine Einheit 14 angeordnet und fixiert gehalten, die eine in nicht dargestellter Weise mit elektronischen Bauteilen bestückte Leiterplatte 16 und zwei jeweils an einem Querende der Leiterplatte 16 angeordnete und damit verbundene Steckverbinder 17 und 18 aufweist. Die beiden Steckverbinder 17 und 18 an den Querenden der Steckkarte 10 sind von außen zugängig, wobei das mit dem Steckverbinder 18 versehene Ende 19 der Steckkarte 10 gleichzeitig als Einsteckende ausgebildet ist.

Beide Gehäuseteile 12 und 13 sind aus dünnem Blech ausgestanzt und halbschalenartig geformt. Das untere Gehäuseteil 12 besitzt einen Boden 21, der an einem großflächigen mittigen Bereich 22 um weniger als die Blechdicke zur Innenseite 26 vorstehend geformt ist sowie dessen Längsränder 23, 24 und dessen einer Endbereich 25 um ein Mehrfaches der Blechdicke über die Innenseite 26 vorstehend geprägt ist. An beide Längsränder 23, 24 schließt sich eine L-förmige Längswand 27, 28 an, die vom einen Ende 29 des Bodens 21 bis zum Beginn des Endbereichs 25 reicht. Der horizontale Längsschenkel 31 der Längswände 27, 28 ist um etwa Blechdicke weiter von der Innenseite 26 weg abgekröpft, während der etwa vertikale oder leicht nach innen geneigte Schenkel 32 der beiden Längswände 27, 28 an seinem freien Endbereich um weniger als die Blechstärke nach innen zum gegenüberliegenden Längsrand hin abgekröpft ist. Dadurch entsteht am freien Ende der Längswände 27, 28 ein Führungskantenbereich 33, der sich nur über einen Teillängenbereich der Längswände 27, 28 erstreckt. Nahe dem Ende 29 des Bodens 21 ist aus dem Schenkel 32 Längswände 27, 28 ein Erdungslappen 36 ausgeklinkt und, in seiner Längsrichtung profiliert, zur Innenseite des unteren Gehäuseteils 12 hin umgebogen. Das Ende 29 ist der jeweiligen Längswand 27, 28 zugewandt mit einem Haltelappen 37, 38 versehen, die verglichen mit der Breite des unteren Gehäuseteils 12 sehr schmal sind, senkrecht vom Boden 21 abstehend umgebogen sind und vor den freien Enden der Längswände 27, 28 enden. Entsprechende Haltelappen 39 und 40 sind vom Endbereich 25 des Bodens 21 aus ebenfalls in Richtung der Längswände 27, 28 etwa senkrecht nach oben umgebogen. Auch diese Haltelappen 39, 40 sind nahe den beiden Längswänder 27, 28 seitlich angeordnet und reichen ebenfalls bis in die Höhe der Abkröpfung der beiden Schenkel 32 der Längswände 27, 28.

Das obere Gehäuseteil 13 ist in ähnlicher Weise wie das untere Gehäuseteil 12 aufgebaut. Das obere Gehäuseteil 13 besitzt ebenfalls einen flächigen Boden 41, dessen mittiger großflächiger Bereich 42 um weniger als die Blechstärke zur Innenseite 46 hin vorgeprägt ist und in Längsränder 43, 44 übergeht, die ebenso wie ein Endbereich 45 um ein Mehrfaches der Blechdicke von der Innenseite 46 weg abgekröpft sind. An die Längsränder 43, 44 schließen sich U-förmige bzw. rinnenförmige Längswände 47, 48 an. Beide Längswände 47, 48 reichen vom einen Ende 49 bis zum Beginn des Endbereichs 45. Der innere Schenkel 51 der Längswände 47, 48 liegt in einer Ebene mit dem Längsrand 43, 44. Der äußere Schenkel 52 verläuft parallel zum inneren Schenkel 51 und der Verbindungsschenkel 53 senkrecht dazu. Ebenso wie das untere Gehäuseteil 12 besitzt auch das obere Gehäuseteil 13 an seinen beiden Enden 49 und 45 Haltelappen 57 bis 60, die jedoch niedriger als die Haltelappen 37 bis 40 des unteren Gehäuseteils 12 sind. Da die Haltelappen 37 bis 40 des unteren Gehäuseteils 12 und die Haltelappen 57 bis 60 des oberen Gehäuseteils 13 in montiertem Zustand der Steckkarte 10 einander gegenüberliegen, ist die Summe ihrer die jeweilige Innenseite 26, 46 überragenden Länge höchstens gleich der jeweiligen lichten Innenweite zwischen den beiden Gehäuseteilen 12 und 13 in montiertem Zustand.

Wie aus Figur 2 ersichtlich ist, ist jedes der Enden 25, 29, 45, 49 in einem Bereich zwischen den Lappen 37 bis 40 bzw. 57 bis 60 mit einem schmalen abgekröpften Streifen 61 zur Erhöhung der Verwindungssteifigkeit bzw. zur Erzielung der Stabilität der Planheit des jeweiligen Gehäuseteils 12, 13 versehen.

Wie der Figur 3 zu entnehmen ist, sind die beiden Gehäuseteile 12 und 13 in zusammengebautem Zustand der Steckkarte 10 in verrastender Weise derart miteinander verbunden, daß die beiden Längswände 47 und 48 des oberen Gehäuseteils 13 die beiden Längswände 27 und 28 des unteren Gehäuseteils 12 umgreifen. Dabei hintergreifen die äußeren Schenkel 52 der Längswände 47, 48 des oberen Gehäuseteils 13 die gegenüber den Längsrändern 23, 24 abgekröpften horizontalen Schenkel 31 der Längswände 27, 28 des unteren Gehäuseteils 12.

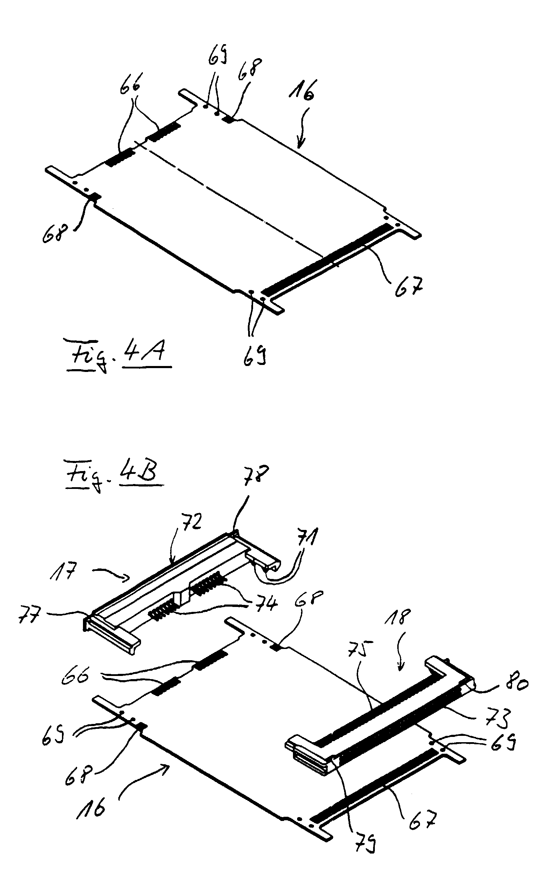

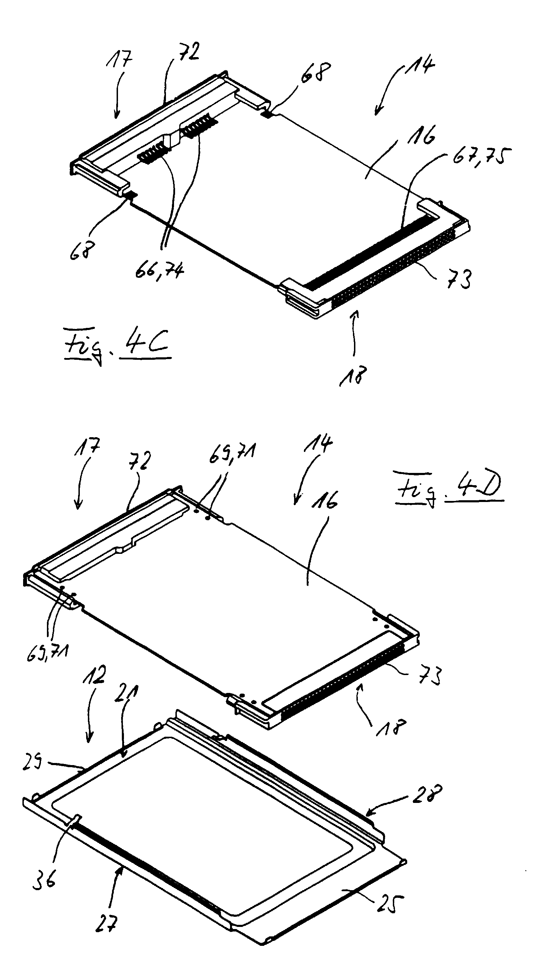

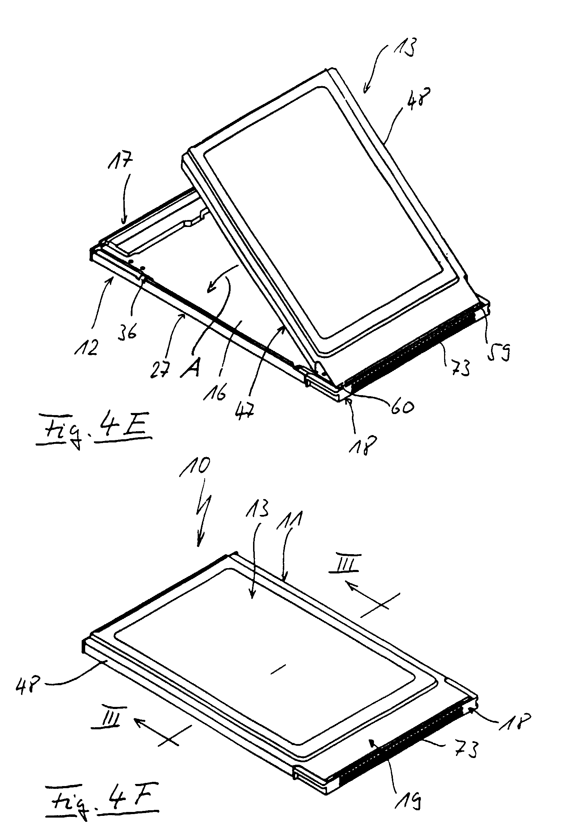

Anhand der Figuren 4A bis 4F ist im folgenden die Herstellung bzw. die Montage der Steckkarte 10 beschrieben. Figur 4A zeigt die Leiterplatte 16, wobei jedoch auf die Darstellung von elektronischen Bauelementen an der Leiterplatte 16 ein- oder beidseitig der Einfachheit halber verzichtet ist. Auch die Leiterbahnen und die Befestigungsbohrungen für die Bauelemente sind nicht gezeigt. Gezeigt sind lediglich Anschlußkontaktanordnungen 66 und 67 für die beiden Steckverbinder 17 und 18 sowie Anschlußkontaktflächen 68 für die beiden Erdungslappen 36. Beidendig besitzt die Leiterplatte 16 desweiteren Aufnahmebohrungen 69 zur Aufnahme von an den Steckverbindern 17, 18 angeformten Stiften 71, wie dies in Figur 4B dargestellt ist. Die Steckverbinder 17, 18 besitzen jeweils einen Isolations-Formstoffkörper, in welchem in nicht näher dargestellter Weise eine Steckerbuchsenanordnung 72, 73 vorgesehen ist, die mit Anschlußfahnenanordnungen 74, 75 versehen sind. Die Steckverbinder 17, 18 werden in der in den Figuren 4B und 4C dargestellten Weise auf die eine Seite der Leiterplatte 16 gesetzt und die Anschlußfahnen 74, 75 werden mit den Anschlußkontakten 66, 67 beispielsweise durch einen Lötvorgang miteinander verbunden. Die so aus der mit Bauteilen bestückten Leiterplatte 16 und den beiden Steckverbindern 17, 18 geschaffene Einheit 14 wird gemäß Figur 4D gewendet und in das untere Gehäuseteil 12 eingesetzt. Dabei werden die Haltelappen 37 bis 40 des unteren Gehäuseteils 12 in entsprechende in den Figuren 4B und 4C ersichtliche Schlitze bzw. Aussparungen 77 bis 80 eingesteckt, so daß die Einheit 14 in Längsrichtung des unteren Gehäuseteils 12 fixiert ist. In Querrichtung des unteren Gehäuseteils 12 ergibt sich eine leichte Verrastung der Seitenränder der Steckverbinder 17, 18 zwischen den beiden Längswänden 27 und 28. In diesem eingesetzten Zustand liegen die beiden Erdungslappen 36 an den Anschlußkontaktflächen 68 der Leiterplatte 16 an.

Gemäß Figur 4E wird das obere Gehäuseteil 13 mit seinen am freien Rand des Endbereichs 45 angeformten Haltelappen 59, 60 voraus in die entsprechenden Schlitze 79, 80 des Steckverbinders 18 eingesetzt, wobei das obere Gehäuseteil 13 unter einem spitzen Winkel zum unteren Gehäuseteil 12 geneigt angeordnet ist. In dieser Anordnung sind die Haltelappen 59, 60 elastisch oder plastisch verformt leicht nach außen gebogen. Diese winklige Anordnung der Gehäuseteile 12, 13 ist derart, daß das den Haltelappen 59, 60 zugewandte Ende der Längswände 47, 48 noch keine Berührung mit dem gegenüberliegenden Bereich der Längswände 27, 28 des unteren Gehäuseteils 12 hat, wie dies aus Figur 4E hervorgeht. Ausgehend von dieser in Längsrichtung der Steckkarte 10 fixierten Lage des oberen Gehäuseteils 13 wird dieses gemäß Pfeil A zum unteren Gehäuseteil 12 hin verschwenkt. Aufgrund des Führungskantenbereichs 33 des Schenkels 32 der Längswände 27, 28 des unteren Gehäuseteils 12 können die Innenkanten des äußeren Schenkels 52 der Längswände 47, 48 des oberen Gehäuseteils 13 durch leichte Auslenkung nach außen über die Längswände 27, 28 gleiten und am Ende der Schwenkbewegung gemäß Pfeil A die horizontalen Schenkel 31 der Längswände 27, 28 verrastend untergreifen (Figur 3). Zur weiteren Vereinfachung und Sicherstellung dieses Einführungsschrittes ist es in nicht näher dargestellter Weise möglich, den dem Endbereich 25 zugewandten Rand des Führungskantenbereichs 33 des Schenkels 32 des unteren Gehäuseteils 12 zur Innenseite hin leicht vorzuprägen bzw. zu verbiegen. Den verrasteten Endzustand, in welchem auch die Haltelappen 57, 58 in die entsprechenden Ausnehmungen 77, 78 der Steckverbinder 17, 18 gelangt sind, zeigt Figur 4F. Daraus ist auch ersichtlich, daß der mit dem Steckverbinder 18 versehene Endbereich 19 gegenüber dem restlichen Bereich der Steckkarte 10 schmäler ist und damit als Steckerende fungieren kann.

## Patentansprüche

1. Rahmenlose Steckkarte (10) für elektronische Datenverarbeitungsgeräte, in etwa länglich rechteckiger, flacher Form, mit einem zwei halbschalenartig ausgebildete Gehäuseteile (12, 13) aufweisenden Gehäuse (11), mit mindestens einer Leiterplatte (16), die in einem der Gehäuseteile (12, 13) formschlüssig aufgenommen ist, und mit mindestens einem an einer Querseite vorgesehenen Steckverbinder (17, 18), **dadurch gekennzeichnet**, daß die beiden halbschalenartig ausgebildeten Gehäuseteile (12, 13) aus dünnem Blech geformt und mit derart geformten Längsseitenwänden (27, 28; 47, 48) versehen sind, daß die Längsseitenwände (46, 48) eines der Gehäuseteile (13, 12) die Längsseitenwände (27, 28) des anderen der Gehäuseteile (12, 13) über im wesentlichen die gesamte Länge verrastend umgreifen.

2. Steckkarte nach Anspruch 1, dadurch gekennzeichnet, daß eines der Gehäuseteile (12, 13) an mindestens einer Querseite von der Außenseite weggerichtete Haltelappen (37 bis 40) aufweist, die in Ausnehmungen (77 bis 80) des mindestens einen Steckverbinders (17, 18) eingreifen.

3. Steckkarte nach Anspruch 1 oder 2, dadurch gekennzeichnet, daß dasjenige Gehäuseteil (13, 12), dessen Längsseitenwände (47, 48) die Seitenwände (27, 28) des anderen Gehäuseteils (12, 13) übergreifen, an mindestens einer Querseite von der Außenseite weggerichtete Haltelappen (57 bis 60) aufweist, die in Ausnehmungen (77 bis 80) des mindestens einen Steckverbinders (17, 18) eingreifen.

4. Steckkarte nach Anspruch 3, dadurch gekennzeichnet, daß die Haltelappen (37 bis 40; 57 bis 60) an der mindestens einen Querseite durch elastisches oder plastisches Verformen schwenkbar sind.

5. Steckkarte nach den Ansprüchen 3 und 4, dadurch gekennzeichnet, daß eines der beiden Gehäuseteile (12, 13) an seinen Längsseitenwänden (27, 28; 47, 48) mit einer nach innen oder außen gerichteten Einführungsprägung versehen ist.

6. Steckkarte nach mindestens einem der Ansprüche 2 bis 5, dadurch gekennzeichnet, daß der Querrandbereich des oder der Gehäuseteile (12, 13) nahe den Haltelappen (37 bis 40; 57 bis 60) mit einer Abkröpfung (61) versehen ist.

7. Steckkarte nach mindestens einem der vorhergehenden Ansprüche, dadurch gekennzeichnet, daß die Längswände (27, 28) eines der Gehäuseteile (12, 13) mit einem ausgeklinkten und nach innen ragenden Erdungslappen (36) versehen sind.

8. Verfahren zum Herstellen und Montieren einer Steckkarte für elektrische Datenverarbeitungssysteme nach mindestens einem der vorhergehenden Ansprüche, dadurch gekennzeichnet, daß die beiden Gehäuseteile aus einem dünnen Blech gestanzt und derart halbschalenartig geformt werden, daß ihre Seitenwände sich bei der Montage formschlüssig umgreifen können, daß die mindestens eine Leiterplatte mit mindestens einem Steckverbinder versehen wird und als Baueinheit in eines der Gehäuseteile unverschiebbar eingesetzt wird und daß das andere Gehäuseteil mit seinem einen Ende auf das eine Gehäuseteil schräg aufgesetzt und durch Verschwenken über das eine Gehäuseteil gerastet wird.

## Claims

1. A frameless plug-in card (10) for electronic data processing devices of somewhat elongate, rectangular, flat formation, comprising a housing (11) having two half-shell-shaped housing parts (12, 13), at least one circuit board (16) interlockingly accommodated in one of the housing parts (12, 13), and at least one plug-in connector (17, 18) arranged on a transverse side, characterised in that the two half-shell-shaped housing parts (12, 13) are formed from thin sheet metal and are provided with longitudinal side walls (27, 28; 47, 48) shaped such that the longitudinal side walls (46, 48) of one of the housing parts (13, 12) interlockingly engage around the longitudinal side walls (27, 28) of the other of the housing parts (12, 13) substantially over the entire length.

2. A plug-in card according to Claim 1, characterised in that on at least one transverse side one of the housing parts (12, 13) comprises retaining tongues (37 to 40) which are directed away from the exterior and which engage in recesses (77 to 80) of the at least one plug-in connector (17, 18).

3. A plug-in card according to Claim 1 or 2, characterised in that the housing part (13, 12), whose longitudinal side walls (47, 48) engage over the side walls (27, 28) of the other housing part (12, 13), is provided on at least one transverse side with retaining tongues (57 to 60) which are directed away from the exterior and which engage in recesses (77 to 80) of the at least one plug-in connector (17, 18).

4. A plug-in card according to Claim 3, characterised in that the retaining tongues (37 to 40; 57 to 60) on the at least one transverse side are deflectable by elastic or plastic deformation.

5. A plug-in card according to Claims 3 and 4,
characterised in that one of the two housing parts (12, 13) is provided on its longitudinal side walls (27, 28; 47, 48) with an inwardly or outwardly directed insertion embossment.

6. A plug-in card according to one of Claims 2 to 5,
characterised in that the transverse edge region of the housing part(s) (12, 13) is provided with an offset (61) close to the retaining tongues (37 to 40; 57 to 60).

7. A plug-in card according to one of the preceding claims, characterised in that the longitudinal walls (27, 28) of one of the housing parts (12, 13) are provided with a notched out and inwardly projecting earthing tongue (36).

8. A method for the production and assembly of a plug-in card for electrical data processing systems according to at least one of the preceding claims, characterised in that the two housing parts are punched from a thin metal sheet and are shaped in the form of half shells, such that their side walls can interlockingly engage around one another upon assembly, that the at least one circuit board is provided with at least one plug-in connector and is immovably inserted as a unit into one of the housing parts, and that at one end the other housing part is obliquely positioned onto the first housing part and is locked by being pivoted onto the first housing part.

## Revendications

1. Carte enfichable (10) sans cadre pour appareils électroniques de traitement de données, sous forme plate rectangulaire plus ou moins allongée, comportant un boîtier (11) présentant deux parties de boîtier (12, 13) en forme de demi-coques, au moins une plaquette à circuits imprimés (16), qui est reçue dans une des parties de boîtier (12, 13) avec adaptation de formes, et au moins un connecteur à fiches (17, 18) situé sur un côté transversal, caractérisée en ce que les deux parties de boîtier (12, 13) en forme de demi-coques sont constituées de tôle mince et sont pourvues de parois latérales longitudinales (27, 28; 47, 48) telles que les parois latérales longitudinales (47, 48) d'une des parties de boîtier (13, 12) enveloppent par encliquetage les parois latérales longitudinales (27, 28) de l'autre partie de boîtier (12, 13) sur sensiblement toute la longueur.

2. Carte enfichable selon la revendication 1, caractérisée en ce que l'une des parties de boîtier (12, 13) présente sur au moins un côté transversal des languettes d'arrêt (37 à 40) qui s'écartent du côté externe et s'enclenchent dans des cavités d'au moins un connecteur à fiches (17, 18).

3. Carte enfichable selon la revendication 1 ou 2, caractérisée en ce que la partie de boîtier (13, 12) dont les parois latérales longitudinales (47, 48) s'accrochent sur les parois latérales (27, 28) de l'autre partie de boîtier (12, 13) présente au moins sur un côté transversal des languettes d'arrêt (57 à 60) qui s'écartent du côté externe et s'enclenchent dans des cavités (77 à 80) d'au moins un connecteur à fiches (17, 18).

4. Carte enfichable selon la revendication 3, caractérisée en ce que les languettes d'arrêt (37 à 40; 57 à 60) peuvent pivoter sur ledit au moins un côté transversal par déformation élastique ou plastique.

5. Carte enfichable selon les revendications 3 et 4, caractérisée en ce que l'une des parties de boîtier (12, 13) est pourvue, sur ses parois latérales longitudinales (27, 28; 47, 48), d'une partie estampée de guidage dirigée vers l'intérieur ou l'extérieur.

6. Carte enfichable selon au moins l'une des revendications 2 à 5, caractérisée en ce que la zone du bord terminal de la ou des parties de boîtier (12, 13) proche des languettes d'arrêt (37 à 40; 57 à 60) est pourvue d'une partie coudée (61).

7. Carte enfichable selon au moins l'une des revendications précédentes, caractérisée en ce que les parois longitudinales (27, 28) de l'une des parties de boîtier (12, 13) sont pourvues d'une languette de mise à la terre (36) encochée et faisant saillie vers l'intérieur.

8. Procédé de fabrication et de montage d'une carte enfichable pour appareils électroniques de traitement de données selon au moins l'une des revendications précédentes, caractérisé en ce que les deux parties de sous la dorme de demi-coques, de façon telle que leurs parois latérales peuvent s'enclencher l'une dans l'autre avec adaptation de formes lors du montage, en ce que la au moins une plaquette à circuits imprimés est pourvue d'au moins un connecteur à fiches et est insérée dans son ensemble dans l'une des parties de boîtier de manière fixe et en ce que l'autre partie de boîtier est appliquée par sa première extrémité sur la première partie de boîtier en oblique et encliquetée par pivotement sur la première partie de boîtier.
